# EUROPEAN PATENT APPLICATION

(11) **EP 2 306 498 A1**
(43) Date of publication of application: **06.04.2011**
(21) Application number: 09766621.8
(22) Date of filing: 15.06.2009
(51) Int. Cl.: H01L 21/3065, B81C 1/00

(54) **METHOD FOR MANUFACTURING MULTISTEP SUBSTRATE**

(30) Priority: 17.06.2008 JP 2008158538
(71) Applicant: Ulvac, Inc., Chigasaki-shi Kanagawa 253-8543 (JP)
(72) Inventor: TANAKA Ai, Chigasaki-shi Kanagawa 253-8543 (JP); KIRA Atsushi, Chigasaki-shi Kanagawa 253-8543 (JP); FUWA Koh, Chigasaki-shi Kanagawa 253-8543 (JP)
(74) Representative: AMMANN PATENTANWÄLTE AG BERN
(86) International application number: PCT/JP2009/060883
(87) International publication number: WO 2009/154173

(57) **Abstract**

A multi-stepped substrate having a plurality of steps is produced by forming, on the principal surface of a substrate, a plurality of masks which are put on top of each other, which differ from each other in the materials used for forming them and which are likewise different, from each other, in the means for peeling off the same; and that the substrate is subjected, in order, to dry-etching operations through the plurality of masks each having a desired shape such that the substrate has a plurality of steps each of which reflects the shape of each corresponding mask.

## Description

### Technical Field

The present invention relates to a method for the production of a multi-stepped substrate.

### Background Art

In the methods for the production of semiconductor devices, micro-machines and MEMS devices, various kinds of three-dimensional structures have been formed according to various combinations of, for instance, the patterning techniques while making use of the lithography technique; various film-forming techniques, for instance, the physical vapor deposition technique such as the vacuum deposition technique and the sputtering technique as well as the chemical vapor deposition techniques; etching techniques such as the wet etching technique and the dry etching technique; and the techniques for laminating or pasting at least two substrates.

It has long been known to form, on a substrate through the micromachining technique, various structures such as the formation of grooves, the formation of hollow structures of thin films and a curved bar structure by the etching of a substrate. According to such a micromachining technique, there have thus been developed various devices having a variety of functions while making the most use of the electrical and mechanical characteristic properties thereof. Further, there have recently been developed systems called µ-TAS (Total Analysis Systems) and Lab-on-a-chip (Laboratory on a chip), in which a fine chemical analysis, a chemical reaction and a biological reaction are carried out within a corresponding highly integrated device, while making use of a number of fine regions, within the device, formed according to the etching technique and such systems would have been put into practical use in the near future.

The etching techniques are divided into the wet etching techniques which make use of the chemical reaction of the substrate to be processed and an etching solution; and dry etching techniques in which a substrate to be processed is bombarded with reactive gas molecules, ions and/or radicals mainly in a vacuum. Moreover, the dry etching techniques are further divided into the reactive gas etching techniques wherein a substrate is etched by exposing the same to a reactive gas; and the plasma etching techniques in which a gas is converted into ions or radicals by the action of a plasma and a substrate is processed or etched with the ions or radicals thus generated. These methods have been properly selected and used depending on the materials of substrates to be processed and the intended shape thereof obtained after the process.

In the dry etching technique, there has conventionally been used a variety of substrate made of, for instance, silicon, silicon oxide and silicon nitride, and etching gases such as halogen atom-containing gases and there have been used etching gases, for instance, fluorine atom-containing gases such as SF₆ and CF₄, chlorine atom-containing gases such as Cl₂ and CCl₄; and fluorine and chlorine atom-containing gases, in the case of, in particular, a substrate made of silicon. In the dry etching technique, however, a problem arises such that any vertical side wall cannot be obtained after the etching treatment.

For this reason, there has been proposed a method in which, when a substrate such as a silicon substrate is processed according to the dry etching technique, CₓF_{y} gas is used as an etching gas and the etching operations are carried out while repeatedly forming a carbon fluoride film for the protection of the resulting side wall, in order to ensure the formation of a vertical side wall (see, for instance, Patent Document 1 specified below).

In addition, there has also been proposed the use of, as an etching gas, a gas such as CHF₃, a mixed gas such as one comprising CF₄ and H₂, and a gas represented by the formula: CₓF_{y} (wherein y/x < 4) (such as C₂F₆), when subjecting a silicon oxide substrate and a silicon nitride substrate to the dry-etching technique (see, for instance, Patent Document 2 specified below).

In the aforementioned dry etching technique, the shape (or pattern) and the material of a mask would greatly contribute to the shape obtained after the etching process and therefore, it is necessary to appropriately select the shape and material of the mask to be used to ensure the desired shape of the substrate obtained after the etching process.

Moreover, there has likewise been proposed a method for the production of a multistage-etched substrate, which makes use of a mask comprising a light-shielding film and a mask comprising a negative resist laying one on top of the other and the whole surface of the masks is exposed to light rays from the side of the same opposite to the patterned side thereof and then the surface of the film is exposed to light rays (see, for instance, Patent Document 3 specified below). In this case, however, it is necessary to use a step for exposing the whole surface from the side of the substrate in the etching procedure for forming each step. This accordingly results in an increase in the number of steps required for the completion of the entire etching operations and this method cannot necessarily process the substrate for forming steps in a high precision and in a simple manner.

### Prior Art Literature

### Patent Documents

Patent Document 1: TOKUHYO Hei 7-503815 (Claims);
Patent Document 2: Japanese Un-Examined Patent Publication 2005-298283 (Claims);
Patent Document 3: Japanese Un-Examined Patent Publication Hei 9-54420 (Claims).

### Summary of the Invention

### Problems That the Invention is to Solve

The processes for processing semiconductor devices have required the use of an advanced technology and have been more sophisticated and more complicated as the degree of integration of such devices have recently been increased and the structure thereof have likewise recently become more complicated. In particular, in the most of the processes for forming a device having a three-dimensional structure such as the MEMS device, the mask-patterning process and the etching process have often been repeated over a number of times.

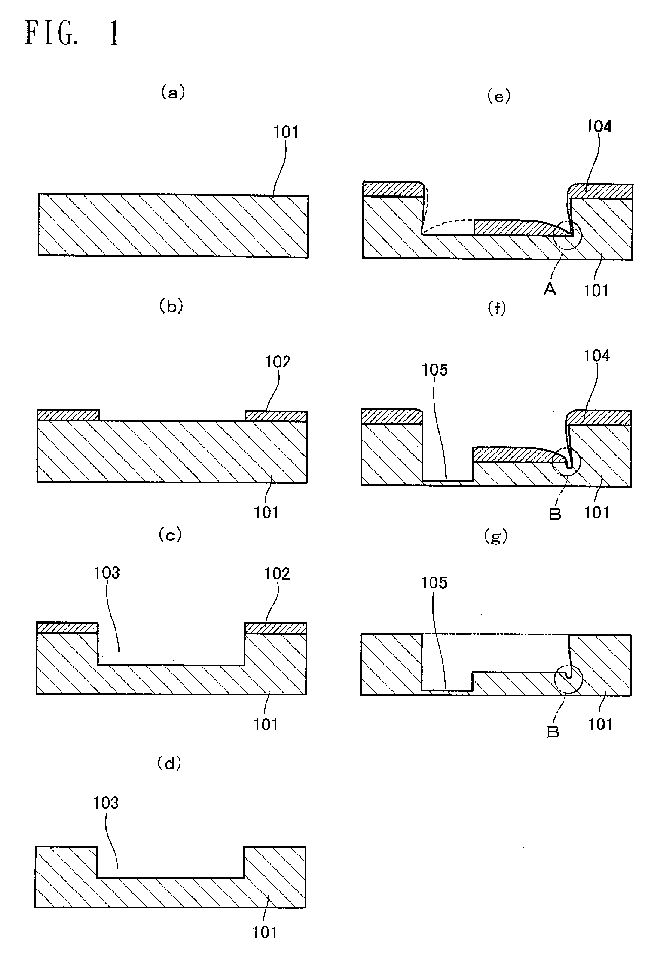

When a groove having complicated steps is formed, it would, for instance, be necessary to carry out the steps such as those shown in Fig. 1. In this connection, Fig. 1 schematically shows the steps for processing a silicon oxide substrate, which were carried out by the inventors of this invention as a preliminary examination.

First, a Cr film is formed on a substrate 101 according to the vacuum deposition technique or the sputtering technique and then the Cr film is patterned using the photolithography technique to thus form a first mask 102 (see Figs. 1(a) and 1(b). Then the substrate is subjected to the dry etching using C₃F₈ gas as an etchant to thus form a first groove 103 having a depth sufficiently greater than the thickness of the first mask 102 (see Fig. 1(c)). Subsequently, the first mask 102 is peeled off using a liquid for peeling off or removing the Cr film (see Fig. 1(d)). A Cr film is then formed on the substrate thus obtained and subsequently subjected to a patterning process, according to the same procedures used above to thus form a second mask 104 which covers the surface of the substrate including a part of the bottom surface of the first groove 103 (see Fig. 1(e)). Then the substrate is subjected to the dry etching process to thus increase the depth of the first groove 103 at the portion which is not covered with the second mask 104 to thus form a second groove 105 (see Fig. 1(f)). Thereafter, the second mask 104 is peeled off using a liquid for peeling off the Cr film (see Fig. 1(g)). In this manner, a groove having two steps can be formed by repeating twice the step for forming a mask and the dry-etching step. According to this process, the thickness of the second mask 104 formed on side wall of the first groove 103 gradually becomes thinner in proportion to the depth of the groove, at the same time, the thickness of the second mask formed on the bottom of the groove likewise gradually becomes thinner towards the intersection between the side wall and the bottom of the groove, as shown in Fig. 1(e), and the thickness of the mask becomes more thinner at the intersection therebetween (see the portion denoted by A in this figure). Accordingly, it is quite difficult to form a second mask 104 having a uniform thickness throughout the whole area thereof. It was thus found that the following problem arises: The portion A wherein the thickness of the second mask 104 is thin among the area covered with the same is also etched in the second etching process as shown in Fig. 1(f) and the so-called "pores or cavities" (the portion indicated by B in this figure) are formed.

In addition, in the foregoing process, a photoresist is applied onto the surface of the substrate provided with a groove according to the spin coating technique and the photoresist is then patterned in order to form the second mask 104. However, the following inconveniences occur: The photoresist cannot uniformly be applied onto the entire surface thereof according to the spin coating technique, depending on the shape factors of the first groove 103 such as the depth and the width thereof and it is impossible to completely cover, with the photoresist, the bottom and sides of the groove and, in particular, the corners thereof and a problem accordingly arises such that the processing conditions are greatly limited. More specifically speaking, the following problems arise: In the case where a Cr film is used, as a mask, as in the foregoing case, the stepped portions and the side wall of the first groove 103 cannot sufficiently be covered with the Cr film for forming the second mask and with the photoresist used for patterning the Cr film according to the lithography technique to thus form the second Cr mask, defects are thus formed on or in the second mask and any desired shape or pattern of the groove cannot be obtained because the defective or damaged portions of the Cr film are undesirably deeply etched. This situation is also true when a photoresist is used as a mask. Furthermore, when the portion processed into the first groove comes in close contact with the second mask (a portion to be processed into a groove), the alignment thereof is insufficient in its precision and as a result, any desired structure cannot be obtained.

Accordingly, it is a general object of the present invention to solve the foregoing problems associated with the conventional techniques and the preliminary experiments and more specifically to provide a method for the production of a substrate having a multi-stepped structure, which comprises the steps of forming a mask comprising a plurality of layers on a substrate, repeatedly carrying out a dry etching process over the times corresponding to the number of the layers constituting the mask so that the groove or step processing is carried out in relation to the substrate and the substrate is precisely and simply processed to form a substrate having a multi-stepped structure.

### Means for the Solution of the Problems

The inventors of this invention have found that the foregoing problems can be solved by first forming, on a substrate, two or more kinds of masks each comprising different materials and then separately subjecting each mask to dry etching or subjecting the masks to multistage etching procedures, whereby a groove having multiple number of steps can be processed or formed and have thus completed the present invention.

Thus, the method for the production of a multi-stepped substrate (a substrate having a multi-stepped structure) according to the present invention is one for producing a multi-stepped substrate having a plurality of steps which comprises working a substrate according to the dry-etching process while making use of a plasma and more specifically the method of the present invention is **characterized in that** multiple steps are formed on a substrate by forming, on the principal surface of a substrate, a plurality of masks which are put on top of each other, which differ from each other in the materials used for forming them and which are likewise different, from each other, in the means for peeling off or removing the same; subjecting, in order, the substrate to dry-etching operations, through the plurality of the masks each carrying a desired shape so that the substrate has a plurality of steps, each of which reflects the shape of each mask.

Thus, multiple steps can be formed on a substrate in a high precision and according to a simple method if forming, on the surface of a substrate, a plurality of masks which are put on top of each other and which differ from each other in the materials used for forming them and then subjecting, in order, the substrate to dry-etching operations, through the plurality of the masks, so that the groove formed on the substrate through each dry-etching procedure can reflects the intended and desired shape of each mask. In addition, according to the method of the present invention, a plurality of masks are formed, which are put on top of each other and which are different, from each other, in the means for peeling off the same and therefore, each of the masks can be peeled off without adversely affecting the underlying mask(s).

In the present invention, it is preferred that each of the foregoing plurality of masks is composed of by (1) a light-insensitive organic polymer material selected from the group consisting of phenolic resins, epoxy resins, acrylic resins, methacrylic resins, polyimides, and polyureas; (2) a photoresist having light-sensitivity and comprising, as a principal component, an organic polymer material selected from the group consisting of phenolic resins, epoxy resins, acrylic resins, methacrylic resins, polyimides, and polyureas; (3) a material selected from the group consisting of metals such as Cr, Ti, Pt, Au, Ag, Al, Ni, Cu, Fe, Zr and Ta, an alloy of at least two of them, as well as an oxide and a nitride of the metal listed above; or (4) a material selected from the group consisting of semiconductor film-forming materials, oxides and nitrides of the foregoing semiconductor film-forming materials, alloys of the foregoing semiconductor film-forming materials and tungsten or molybdenum, and SiON.

In the present invention, it is preferred that one of the foregoing masks is one made of a resin. The term "resin" used herein is not restricted to any particular one insofar as it is constituted by an organic polymeric material, but it is preferably a member selected from the group consisting of the resins listed above. More preferably used herein are light-sensitive resins capable of being patterned through the photolithography technique, in other words, photoresists, since a reduced number of steps are required for the formation of a mask. As principal components of the photoresists, there may be listed, for instance, phenolic resins (novolak resins or the like), polyimides, polyureas, epoxy resins, acrylic resins and methacrylic resins, which are commonly easily available and have been listed above. Alternatively, when using a resin which is not a photoresist, a mask consisting of such a resin material can be prepared according to, for instance, the method as will be detailed below.

One of the foregoing masks is preferably a Cr film or an aluminum film. This is because, Cr may quite easily react with another substance to form a compound, it permits the formation of a stable film directly on a variety of materials, as will be clear from the fact that it has currently been used as a material for forming an adhesive layer and further the patterning thereof can be carried out according to the conventionally known means such as the lift-off technique, the wet etching technique or the dry etching technique.

When the surface of the foregoing substrate to be processed is composed of silicon, one of the masks is preferably a silicon oxide or silicon nitride film. This silicon oxide or silicon nitride film can be formed according to the physical vapor deposition technique such as the evaporation technique and the sputtering technique; the chemical vapor deposition technique; and the spin coating technique.

In addition, when the surface of the foregoing substrate to be processed is composed of silicon oxide (for instance, quartz or a thermally oxidized film), silicon nitride or SiON, one of the masks is preferably a silicon film. Such a silicon film can be produced according to a means, for instance, the physical vapor deposition technique such as the sputtering technique and the evaporation technique; the chemical vapor deposition technique; and the spin coating technique.

The method for the production of a multi-stepped substrate according to the present invention is one in which a multi-stepped substrate having a plurality of steps is produced by processing a substrate whose surface is composed of silicon according to the dry etching technique while making use of a plasma and in the method of the present invention, it is preferred to form a multi-stepped substrate having a plurality of steps by forming, on the principal surface of a substrate, a plurality of masks which are put on top of each other, which differ from each other in the materials used for forming them and which are likewise different, from each other, in the means for peeling off the same, in this respect, one of the plurality of masks being one consisting of a silicon oxide film or a silicon nitride film prepared according to the chemical vapor deposition technique; and then subjecting, in order, the substrate to dry-etching operations, through the plurality of masks each having a desired shape, so that the substrate has a plurality of steps each of which reflects the shape formed on each corresponding mask. In this case, it is preferred that one of the masks consists of a resin.

Alternatively, the method for the production of a multi-stepped substrate according to the present invention is one in which a multi-stepped substrate having a plurality of steps is produced by processing a silicon oxide substrate or a silicon nitride substrate according to the dry etching technique while making use of a plasma and in the method of the present invention, it is preferred to produce a multi-stepped substrate having a plurality of steps by forming, on the principal surface of the silicon oxide substrate or the silicon nitride substrate, a plurality of masks which are put on top of each other, which differ from each other in the materials used for forming them and which are likewise different, from each other, in the means for peeling off the same, in this respect, one of the plurality of masks being one consisting of a silicon film prepared according to the sputtering technique or the evaporation technique; and then subjecting, in order, the substrate, through the plurality of masks each having a desired shape, to dry-etching operations so that the substrate has a plurality of steps each of which reflects the shape of on each corresponding mask. In this case, it is preferred that one of the masks consists of a resin.

### Effects of the Invention

The present invention would permit the achievement of such an effect that a multi-stepped substrate can be produced by carrying out a plurality of processing steps for producing a plurality of steps on a substrate in high precision and by a simple method.

### Brief Description of the Drawings

Fig. 1 is a schematic flow diagram showing the method of a preliminary experiment carried out for producing a multi-stepped substrate having steps.
Fig. 2 is a schematic flow diagram showing the details of the method for producing a multi-stepped substrate having a plurality of steps according to the present invention.
Fig. 3 is a diagram schematically showing the shape of a multi-stepped substrate having two steps observed after the working of the substrate and produced according to the procedure used in Example 1 and, more specifically, Fig. 3(a) is a top plan view of a processed substrate and Fig. 3(b) is a cross sectional view of a processed substrate.
Fig. 4 is a schematic flow diagram showing the processes for the production of a multi-stepped substrate having two steps, produced according to the procedures used in Example 1.
Fig. 5 is an electron microscope photograph showing the cross section of a silicon substrate obtained in Example 1.
Fig. 6 is a schematic flow diagram showing the processes for the production of a multi-stepped substrate having three steps, produced according to the procedures used in Example 2.
Fig. 7 is a schematic flow diagram showing the processes for the production of a multi-stepped substrate having three steps, produced according to the procedures used in Example 3.

### Mode for Carrying out the Invention

According to an embodiment of the method for the production of a multi-stepped substrate relating to the present invention, multiple layers of masks each for protecting the corresponding region on the principal surface of a substrate, which should not be peeled off or removed through dry etching, are formed and then the substrate is dry etched in such a manner that the substrate has a plurality of steps each of which reflects the shape of each corresponding mask. In this case, a fine groove-forming processing is carried out by forming, on a substrate, a plurality of masks which are put on top of each other, which differ from each other in the materials used for forming them and which are likewise different, from each other, in the means for peeling off the same and then subj ecting the substrate, in order, to dry etching operations, while making use of a plasma, through the plurality of masks each having a desired shape, so that the substrate has a plurality of steps each of which reflects the shape of each corresponding mask and therefore, the method of the present invention permits the easy implementation of the groove-forming processing for the production of a multi-stepped substrate having a plurality of fine steps in high precision.

The substrate to be processed according to the present invention may be any one insomuch as it can be etched by the dry etching technique. Examples of such substrate usable in the present invention include those selected from the group consisting of silicon substrates, silicon oxide substrates, silicon nitride substrates, sapphire substrates, glass substrates, quartz substrates, lithium tantalite substrates, lithium niobate substrates, silicon carbide substrates, gallium arsenide substrates, and gallium nitride substrates, as well as laminated substrates each comprising a laminate of these materials. In the case of such a laminated substrate, the layer which is not etched according to the method of the present invention is not limited in its material. Moreover, it is also possible to use, for instance, a waveguide substrate (PLC) as a packaging base for mounting a semiconductor optical amplifier (SOA) as an optical semiconductor. Furthermore, there can likewise be used a substrate provided thereon with a film made of a material which would never be damaged by a means for the peeling off or removal of the mask.

The shape of the substrate is not likewise limited to any particular one insomuch as a plurality of steps can be formed on the same and it may be one having a flat surface or those having convex and/or concave spherical surfaces.

As has been discussed above, the present invention thus permits the simple implementation of such a multi-stage groove-forming processing in high precision by forming or laminating, on the principal surface of a substrate, a plurality of masks and then subjecting the substrate to dry etching.

The material for forming the mask can properly selected depending on the kind of the substrate to be processed and a plurality of materials for forming the masks are selected and used in combination in such a manner that they are different, from each other, in the means for peeling off the same.

Examples of materials used for forming such a mask include (1) light-insensitive organic polymer materials selected from the group consisting of, for instance, phenolic resins (such as novolak resins), epoxy resins, acrylic resins, methacrylic resins, polyimides and polyureas; (2) light-sensitive photoresists each of which is a resin mainly comprising an organic polymer material selected from the group consisting of, for instance, phenolic resins (such as novolak resins), epoxy resins, acrylic resins, methacrylic resins, polyimides and polyureas, or commercially available photoresist materials selected from the group consisting of, for instance, OFPR (the trade name a product available from Tokyo Ohka Kogyo Co. , Ltd.), TMSR-iN (the trade name of a product available from Tokyo Ohka Kogyo Co., Ltd.), SU-8 (the trade name of a product available from Kayaku Microchem K.K.), and ZPN (a product available from Zeon Corporation); (3) metals selected from the group consisting of Cr, Ti, Pt, Au, Ag, Al, Ni, Cu, Fe, Zr and Ta, alloys of at least two of the foregoing metals, and oxides and nitrides of these metals (such as Al₂O₃, and AlN); (4) semiconductor film-forming materials such as silicon (Si), oxides of these semiconductor film-forming materials (such as SiO₂) and nitrides thereof (such as SiₓN_{y}), alloys of these semiconductor film-forming materials with, for instance, tungsten and molybdenum (such as WSi, MoSi) and SiON. Among them, preferred are photoresists and Cr while taking into consideration the convenience in use.

In this respect, however, the use of a material identical to that of the surface to be processed as a material for forming a mask is not preferred since the surface of the substrate to be processed may be damaged upon the peeling off of the mask. In other words, when the surface to be processed is composed of silicon, silicon is improper for use as a mask-forming material. Similarly, when the surface to be processed is composed of quartz or SiO₂, it is not preferred to use silicon oxide (SiO₂) as a mask-forming material. Moreover, when using a combination of materials which are damaged by the means for the peeling off of the mask, for instance, when using the combination of the surface to be processed, which is composed of quartz or SiO₂, with SiN or SiON as a mask-forming material, the surface to be processed is damaged by the means for the peeling off of the mask and therefore, SiN or SiON is improper for use as a mask- forming material. On the other hand, any material may be used as a mask-forming material inasmuch as the surface to be processed is not affected by the means for the peeling off of the mask-forming material. For instance, if the surface to be processed is composed of silicon, it is possible to select silicon oxide (SiO₂), silicon nitride (SiₓN_{y}) or SiON as a material for forming a mask. Alternatively, when the surface to be processed is composed of, for instance, silicon oxide (SiO₂), silicon nitride (SiₓN_{y}), or SiON, silicon may be used as a mask material.

When using, as a mask material, a light-insensitive organic polymer material selected from the resins listed above, the mask composed of such a resin can be produced according to the following procedures. For instance, (1) there is placed, on a substrate, a thin plate or a film made of a metal or a resin, on which holes are formed in a desired shape, a resin as a mask-forming material is applied onto the plate or film according to, for instance, the spray coating technique, the spin coating technique or the evaporation technique and thereafter the thin plate or the film is removed to thus give a mask carrying an intended pattern. (2) A resin as a mask-forming material is applied onto a photoresist which has preliminarily been applied onto a substrate and then patterned, according to, for instance, the spray coating technique, the spin coating technique or the evaporation technique and then the resist is removed through the use of, for instance, an alkaline substance-containing solution (such as a resist-peeling off liquid 105 available from Tokyo Ohka Kogyo Co., Ltd.) to thus give a mask carrying an intended pattern. (3) A resin as a mask-forming material is coated on a substrate, a photoresist layer is then formed on the resin film, the photoresist is patterned, followed by the O₂ ashing, the processing of the resin film through etching and the final removal of the photoresist layer using an alkaline substance-containing solution (such as a resist-peeling off liquid 105 available from Tokyo Ohka Kogyo Co., Ltd.) to thus give a mask carrying an intended pattern.

Now, the relations between the film-forming techniques used for the foregoing mask-forming materials and the means for the peeling off thereof are summarized in the following Table 1, but they are simply listed by way of example and it is a matter of course that the present invention is not restricted to these techniques inasmuch as they can be used for the achievement of the intended purposes of the present invention.

**Table 1**

| Mask-Forming Material | Film-Forming Method | Means for Peeling off |
|---|---|---|
| Resins, for instance, phenolic resins (such as novolak resins), epoxy resins, acrylic resins, methacrylic resins, polyimides, and polyureas;, photoresists each comprising the foregoing resin as a main component; and commercially available photoresists | Spin coating; spray coating; squeegee;; and vapor deposition polymerization | Alkaline solutions; acidic solutions; organic solvents such as acetone and methyl pyrrolidone; surfactants; and oxygen plasma ashing |
| Metals such as Cr, Ti, Pt, Au, Ag, Al, Ni, Cu, Fe, Zr and Ta; alloys of at least two of these metals; and oxides and nitrides of these metals | PVD (evaporation, sputtering); CVD (MOCVD); plating; sol-gel technique (such as spin coating); thermal oxidation; and direct; nitridation using, for instance, ammonia | Wet etching techniques using, for instance, a variety of etchants such as strong acids, strong alkalis, potassium iodide, and ferric chloride; and dry etching techniques |
| Semiconductor film-forming materials such as silicon, oxides and nitrides of these semiconductor film-forming materials, alloys of these semiconductor film forming materials with, for instance, tungsten and molybdenum; and SiON | PVD, various kinds of CVD techniques, thermal oxidation, thermal nitridation | Wet etching techniques using, for instance, strong alkaline aq. solutions, potassium hydroxide aq. solution, tetramethyl-ammonium hydroxide aq. solution, hydrofluoric acid, aq. hydrogen peroxide solution; and dry etching techniques |

Moreover, as has already been described above, it is not preferred to use, as a mask-forming material, such a material that the surface to be processed receives any damage due to the action of a means for peeling off the resulting mask.

If selecting desired mask-forming materials among those illustrated in the foregoing Table 1; appropriately combining desired mask-forming materials thus selected, which are different, from each other, in the means for peeling off the same; forming, on the principal surface of a substrate, a plurality of masks which are put on top of each other and which differ from each other in the materials used for forming them; and then subjecting the substrate to dry etching through each individual mask, each mask can be peeled off after the completion of each etching procedure, using a means for peeling off each corresponding mask-forming material, without adversely affecting the underlying mask or masks. In this respect, the mask-forming materials are divided into several groups, in Table 1, but it is sufficient, in the present invention, that a plurality of mask-forming materials used in combination are selected in such a manner that the means for peeling off these mask-forming materials are different from each other, whether they belong to the same group or not.

For instance, in the case of a photoresist, the film of OFPR (the trade name of a product available from Tokyo Ohka Kogyo Co., Ltd.) can be peeled off using acetone or methyl pyrrolidone; and the film of SU-8 (the trade name of a product available from Kayaku Micro-Chem K.K.) has tolerance to organic solvents such as acetone or methyl pyrrolidone, but can be peeled off with a peeling liquid comprising a strong oxidizing agent or through the ashing with an oxygen plasma. As has been discussed above, the method of the present invention can be implemented without adversely affecting the underlying mask or masks, through the use of photoresists which are different from each other in the means for peeling off the same, even though these mask-forming materials belong to the same photoresist group.

Then, examples of typical combination of the mask-forming materials listed in the foregoing Table 1 and the means for the peeling off thereof will be summarized in the following Table 2, while taking the implementation of the processing or formation of a multi-stepped groove having two steps by way of example. Table 2 illustrates preferred relation between the material for forming a mask 1 (lower mask) and the means for the peeling off thereof; and the preferred relation between the material for forming a mask 2 (upper mask) and the means for the removal thereof, used when forming, in order, the mask 1 and the mask 2 to thus form a groove. Even in the case where implementing the formation of a multi-stepped groove having more than two steps, it would be sufficient that each mask-forming material and each means for the peeling off thereof are appropriately combined according to the foregoing manner, a plurality of masks are, in order, formed on a substrate and then the substrate is processed to form desired grooves.

**Table 2**

| No. | Mask 1 (lower mask) | | Mask 2 (upper mask) | |
|---|---|---|---|---|
| | Mask-forming material | Mask-peeling off Means | Mask-forming material | Mask-peeling off Means |
| 1 | Metal: Al | Al-etching soln.* | Resin: polyimide | Oxygen-ashing |
| 2 | Metal: Ni | Ni-etching soln.* | Photoresist: OFPR | Organic solvent |
| 3 | Metal: Au | Au-etching soln.* | Metal: Cr | Cr-etching soln.** |
| 4 | Metal: Cr | Cr-etching soln.** | Metal: Au | Au-etching soln.* |
| 5 | Metal: Pt | Hydrofluoric acid | Semiconductor: Si | Alkaline soln. |
| 6 | Semiconductor : Si | Alkaline soln. | Metal: Pt | Hydrofluoric acid |
| 7 | Metal: Cr | Cr-etching soln.** | Si oxide (nitride): SiO (SiN) | Hydrofluoric acid |
| 8 | Si oxide (nitride) : SiO (SiN) | Hydrofluoric acid | Metal: Cr | Cr-etching soln.** |
| 9 | Metal: Ti | Hydrofluoric acid | Si alloy: WSi | Aq. H₂O₂ soln. |
| 10 | Alloy: WSi | Aq. H₂O₂ soln. | Metal: Ti | Hydrofluoric acid |
| 11 | Metal oxide: Cu₂O | Acid·alkali | Resin: polyimide | Oxygen-ashing |
| 12 | Metal oxide: Ta₂O₅ | Hydrofluoric acid | Photoresist: SU-8 | Soln. of Oxidizing agent |
| 13 | Metal oxide: Al₂O₃ | Phosphoric acid | Metal: Cu | Ferric chloride |
| 14 | Metal oxide: Al₂O₃ | Phosphoric acid | Semiconductor: Si | Alkaline soln. |
| 15 | Semiconductor : Si | Alkaline soln. | Metal oxide: Al₂O₃ | Phosphoric acid |
| 16 | Metal oxide: Al₂O₃ | Phosphoric acid | Si oxide (nitride): SiO (SiN) | Hydrofluoric acid |
| 17 | Si oxide (nitride) : SiO (SiN) | Hydrofluoric acid | Resin: polyurea | Oxygen-ashing |
| 18 | Resin: polyurea | Oxygen-ashing | Si oxide (nitride): SiO (SiN) | Hydrofluoric acid |
| 19 | Si oxide (nitride) : SiO (SiN) | Hydrofluoric acid | Photoresist: TMSR-iN | Oxygen-ashing |
| 20 | Photoresist: TMSR-iN | Oxygen-ashing | Si oxide (nitride): SiO (SiN) | Hydrofluoric acid |
| 21 | Si oxide (nitride) : SiO (SiN) | Hydrofluoric acid | Semiconductor: Si | Alkaline soln. |
| 22 | Semiconductor : Si | Alkaline soln. | Si oxide (nitride): SiO (SiN) | Hydrofluoric acid |
| 23 | Si oxide (nitride) : SiO (SiN) | Hydrofluoric acid | Si alloy: MoSi | HF Ammonium + Aq. H₂O₂ soln. |
| 24 | Si alloy: MoSi | HF Ammonium + Aq. H₂O₂ soln. | Si oxide (nitride): SiO (SiN) | Hydrofluoric acid |
| 25 | Si alloy: MoSi | HF Ammonium + Aq. H₂O₂ soln. | Resin: acrylic resin | Oxygen-ashing |
| 26 | Si alloy: MoSi | HF Ammonium + Aq. H₂O₂ soln. | Photoresist: ZPN | Organic solvent |
| 27 | Si alloy: WSi | Aq. H₂O₂ soln. | Metal: Cr | Cr-etching soln.** |
| 28 | Si alloy: WSi | Aq. H₂O₂ soln. | Metal oxide: Cr₂O₃ | Acid |
| 29 | Si alloy: WSi | Aq. H₂O₂ soln. | Semiconductor: Si | Alkaline soln. |
| 30 | Semiconductor : Si | Alkaline soln. | Si alloy: WSi | Aq. H₂O₂ soln. |

| | | | | |
|---|---|---|---|---|
| *: Available from Kanto Chemical Co., Ltd. **: Available from Hayashi Pure Chemical Ind., Ltd. | | | | |

According to the present invention, one of the plurality of masks is preferably made of silicon oxide or silicon nitride when subjecting a substrate having the surface consisting of silicon to the step-forming processing and, in this case, the processing method of the present invention permits the simple implementation of the processing for forming steps in higher precision. If the surface of a substrate is composed of silicon, the substrate may be one completely consisting of silicon or a laminated substrate whose upper most layer consists of silicon. In addition, it would be sufficient to adopt, for instance, the sputtering technique or the chemical vapor deposition technique (CVD technique) as a means for forming a film of silicon oxide or silicon nitride.

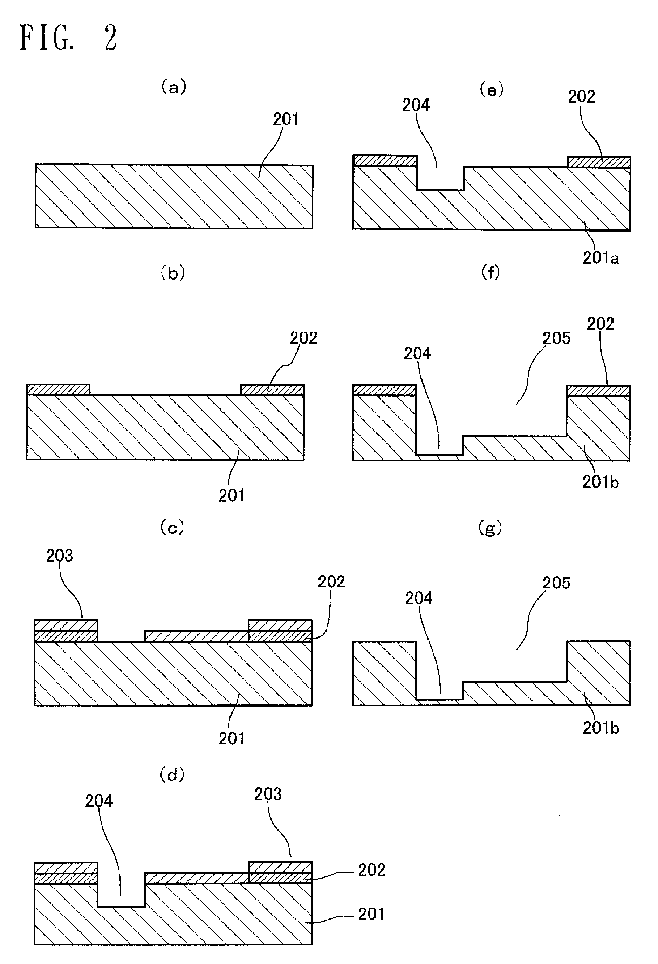

As an example of the method for producing a multi-stepped substrate having a plurality of steps according to the present invention, wherein the steps are formed on a substrate by processing the same through etching while using a substrate, a mask-forming material, a film-forming method and a means for the peeling off thereof as has been described above, a multi-stage method for the production of a groove having two steps will be described below in detail with reference to the working processes as shown in Figs. 2(a) to 2(g).

First of all, a film subsequently serving as a first mask and consisting of a mask-forming material is formed on the surface of a substrate 201 according to the film-forming method listed in Table 1 and the film thus formed is subjected to a patterning operation using, for instance, the photolithography technique to thus form the first mask 202 (see Figs. 2(a) and 2(b)). Then a film subsequently serving as a second mask and consisting of a mask-forming material which differs from the first mask 202 in the materials used for forming the same and which is likewise different, from the first mask 202, in the means for peeling off the same is formed on the surface of the substrate 202 including the surface of the first mask thus obtained and the film thus formed is likewise subjected to a patterning operation to thus form a second mask 203 on the first mask 202 and a part of the surface of the substrate 201 (see Fig. 2(c)). Then the resulting substrate is subjected to dry etching to form a groove 204 which reflects the shape of the second mask 203 and to thus give a substrate 201a having the groove 204 (see Fig. 2(d)). Thereafter, the second mask is peeled off so that the first mask 202 and the surface of the substrate 201a are thus exposed (Fig. 2(e)). At this stage, a groove 205 which reflects the shape of the first mask 202 is formed by again subjecting the substrate 201a to dry etching to dig or burrow the substrate at the area of the groove 204 and the exposed surface of the substrate 201a which are not covered with the first mask 202 and to thus give a substrate 201b having steps or grooves 204 and 205 (see Fig. 2(f)). Finally, the first mask 202 is peeled off to thus give the substrate 201b having the grooves 204 and 205 which come in close contact with each other (see Fig. 2(g)). Thus the working for forming a multi-stepped groove having two steps can easily be implemented in high precision.

As has been described above, according to the present invention, the procedures for forming grooves on a substrate are carried out in such an order that smaller grooves are first formed and then larger grooves are formed subsequent thereto and accordingly, the mask pattern used for the first etching is smaller than that used for the second etching.

Even in the case where implementing the formation of a multi-stepped groove having at least three steps, the multistage processing for forming a groove having a plurality of steps can be implemented by forming a plurality of masks on a substrate, subjecting the substrate provided thereon with a plurality of masks to dry etching for each mask and subsequently peeling off each mask to thus dig a groove which reflects the shape or pattern of each mask, according to the process as shown in Figs. 2(a) to 2(g).

The dry etching process for forming the grooves 204 and 205 in the foregoing method will hereunder be described in more detail.

The substrate on which the second mask 203 has been formed is subjected to dry etching according to the DRIE (deep reactive ion etching) technique, as has been described above. First, the substrate introduced into a vacuum chamber is placed on an electrostatic chuck and adhered to the same, followed by the evacuation of the chamber to a vacuum, simultaneous with the introduction of an inert gas for cooling into the vacuum chamber under the substrate to thus cool the surface of the substrate in such a manner that the temperature of the surface is set at a predetermined level (for instance, 80 to 100 °C) during the electric discharge process. Then a gas (such as C₄F₈) for forming a protective film is introduced into the vacuum chamber, while adjusting the pressure within the chamber such that it is maintained at a predetermined level (for instance, 1 to 10 Pa and preferably 2 Pa), a desired electric power (such as 500 W to 1 kW) is applied to an antenna over a predetermined time period (for instance, 5 to 20 seconds and preferably 15 seconds) to thus form a protective film on the entire surface of the substrate. Thereafter, a reactive gas (such as SF₆ gas) is introduced into the vacuum chamber to a predetermined pressure within the chamber (for instance, 1 to 10 Pa and preferably 5 Pa), a desired electric power (such as 500 W to 1 kW) is applied to an antenna and a predetermined electric power as the bias power (for instance, 30 to 100 W) is applied to the substrate, each over a predetermined time period (for instance, 5 to 20 seconds and preferably 15 seconds) to thus etch the substrate. The protective film-forming step and the substrate-etching step as described above are repeated to carry out the etching of the substrate perpendicularly while protecting the side wall of the groove thus formed.

In the foregoing dry etching procedure, it is preferred to use, as the etching gas, at least one gas containing halogen atom selected from the group consisting of fluorine, chlorine, bromine and iodine, when using a substrate which is composed of, for instance, silicon, siliconoxide, siliconnitride, sapphire, lithium tantalate, lithium niobate, silicon carbide, gallium arsenide, and gallium nitride.

When using a silicon substrate, usable herein as the etching gases for processing such a substrate further include, for instance, fluorine atom-containing gases such as SF₆, CF₄, NF₃, SiF₄, BF₃, CBrF₃, and XeF₂; chlorine atom-containing gases such as Cl₂, CCl₄, SiCl₄, PCl₃, BCl₃, and HCl; and fluorine and chlorine atom-containing gases such as CₗClₘFₙ.

Moreover, when subjecting a silicon oxide substrate or a silicon nitride substrate to dry etching, usable herein as the etching gases for processing the same include, for instance, gases such as CHF₃, CH₂F₂ and CH₃F; a mixed gas comprising CF₄ and H₂; gases represented by the formula: CₓF_{y} (y/x <4) such as C₂F₆ and C₃F₈.

When subjecting the foregoing silicon dioxide (SiO₂) substrate to dry etching, the substrate sent in a vacuum chamber was first placed on an electrostatic chuck and adhered to the same, followed by the evacuation of the chamber to a vacuum, simultaneous with the introduction of an inert gas for cooling into the vacuum chamber under the substrate to thus cool the surface of the substrate in such a manner that the temperature of the surface was cooled down to a temperature ranging from 80 to 100°C during the electric discharge process. Then C₃F₈ gas is introduced into the vacuum chamber to a pressure, within the chamber, ranging from 0.5 to 5 Pa (preferably 0.5 Pa) and then an electric power ranging from 500 W to 2 kW is applied to an antenna and an electric power ranging from 50 to 500 W as the bias power is applied to the substrate. Thus, the substrate can be etched.

With regard to the effect of the multistage etching according to the present invention on the shape of the resulting groove, if the etching conditions for each etching step are identical to one another, the depth of the.groove obtained after the first etching step would be reduced after the completion of the subsequent etching step. For this reason, in order to obtain a groove having an intended shape (or depth), the degree of the change in its shape is preliminarily determined or confirmed and the depth of the groove to be formed through the first etching is beforehand adjusted, for instance, in such a manner that it is set at a level deeper than the intended one while taking into account the degree of the change in the depth. Moreover, if the opening of the groove is so large that gases can sufficiently enter into the same, the difference in the etching rate can be reduced to some extent by implementing the etching while any bias power is scarcely applied.

In the foregoing, there has been described a case wherein a plurality of masks are formed on the principal surface of a substrate and grooves having desired depths are formed, in order, through dry etching procedures to thus leave the bottom surface of the substrate. However, the etching is continued till even the bottom of the substrate is removed or the grooves are formed through the substrate, depending on the applications of the multi-stepped substrate produced according to the present invention. Alternatively, the grooves may be formed through the substrate by digging the same through etching from the side of the substrate opposed to the principal surface thereof, in the case where the substrate has a large thickness.

### Example 1

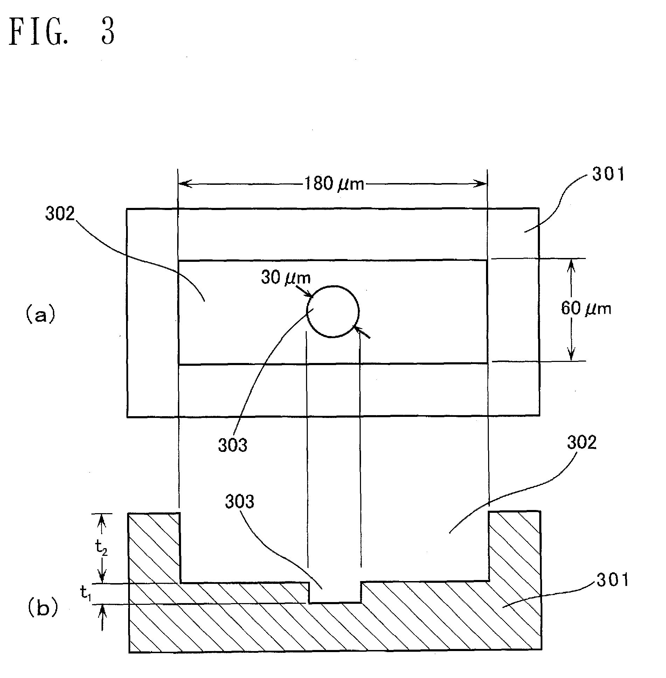

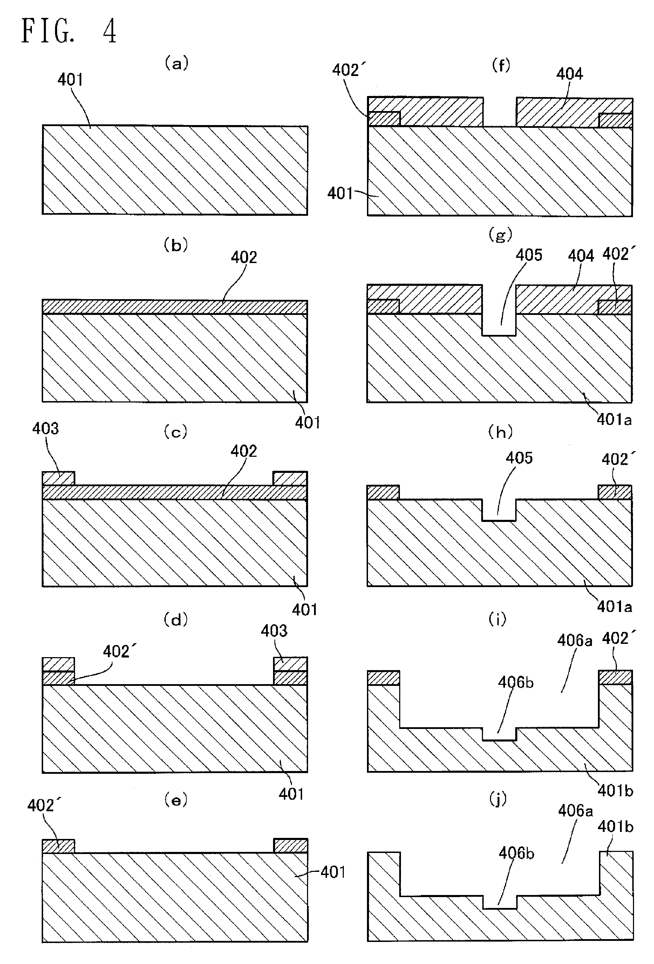

In this Example, there will be described the processed shape of a substrate 301 as shown in Figs. 3(a) and 3(b) as well as the processing for forming a groove having two steps which is carried out according to the process as shown in Figs. 4(a) to 4(j).

Fig. 3(a) showing the shape of the groove formed after the completion of the groove-forming processing of a substrate in this Example is a top plan view of the substrate, and Fig. 3 (b) is a cross sectional view thereof. In this Example, there were formed a rectangular groove 302 having a size of 180×60µm and a circular groove 303 having a diameter ϕ of 30µm such that these grooves had a step.

Referring now to Fig. 4, a silicon oxide film 402 was first formed on a substrate 401 (silicon substrate) in a thickness of 1µm, according to the plasma-assisted CVD technique using tetraethoxy silane (TEOS) gas (see Figs. 4(a) and 4(b)). Then a film of OFPR (the trade name of a product available from Tokyo Ohka Kogyo Co., Ltd.) as a photoresist was formed on the silicon oxide film 402 and the OFPR film was subjected to the patterning thereof using the photolithography technique to thus obtain a pattern 403 (see Fig. 4(c)), then the silicon oxide film 402 was dry-etched through the pattern 403 using the plasma of C₄F₈, C₃F₈ to thus make the surface of the substrate 401 expose (see Fig. 4 (d)). Thereafter, the pattern 403 consisting of OFPR was peeled off from the substrate using acetone to thus make the corresponding pattern of the silicon oxide film expose and the latter was used as a first mask 402' (Fig. 4(e)). Subsequently, an OFPR film was formed on the surface of the first mask 402' and the exposed surface of the substrate 401 and then the OFPR film was subjected to a patterning operation according to the photolithography technique to thus form a second mask 404 (see Fig. 4(f)).

The substrate treated according to the foregoing processes was dry-etched according to the DRIE technique. More specifically, the substrate introduced into a vacuum chamber was first placed on an electrostatic chuck and adhered to the same, followed by the evacuation of the chamber to a vacuum, simultaneous with the introduction of an inert gas for cooling into the vacuum chamber at the lower part of the substrate to thus cool the surface of the substrate in such a manner that the temperature of the surface was set at a level ranging from 80 to 100°C, during the electric discharge process. Then C₄F₈ gas was introduced into the vacuum chamber, while adjusting the pressure within the chamber to 2 Pa, an electric power ranging from 500 W to 1 kW was applied to an antenna for 15 seconds to thus form a protective film on the entire surface of the substrate. Thereafter, SF₆ gas as a reactive gas was introduced into the vacuum chamber to a pressure within the chamber of 5 Pa, an electric power ranging from 500 W to 1 kW was applied to an antenna and an electric power, as the bias power, ranging from 30 to 100 W was applied to the substrate, each for 15 seconds to thus dry-etch the substrate so as to correctly reflect the shape of or the pattern formed on the second mask 404. The protective film-forming step and the substrate-etching (dry-etching) step as described above were repeated to carry out the etching of the substrate perpendicularly while protecting the side wall of the groove thus formed.

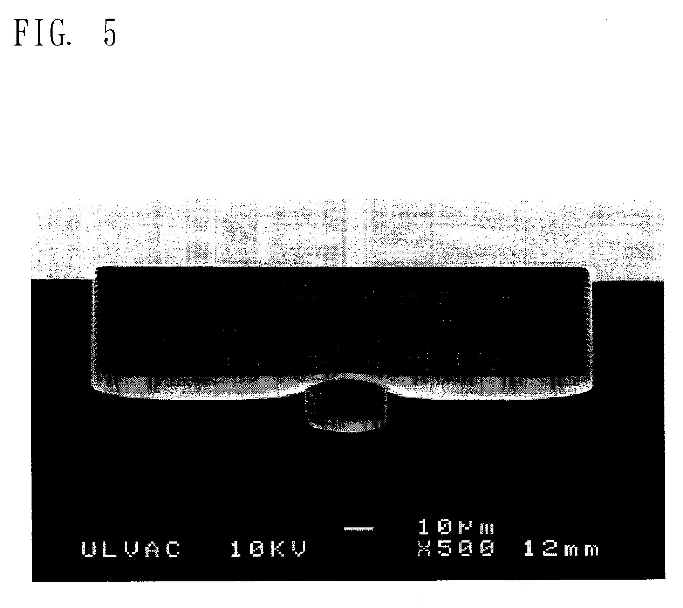

Thus, there was formed a groove 405 having a depth of 20.5µm, which faithfully reflected the shape of the second mask 404 consisting of OFPR and a substrate 401a having the groove 405 thus formed (see Fig. 4(g)). Then the second mask 404 was peeled off using acetone (see Fig. 4(h)), thereafter the substrate was subjected to dry-etching through the first mask 402' consisting of silicon oxide according to the DRIE technique under the same conditions used above and subsequently the mask 402' was peeled off. As a result, there was obtained a substrate 401b having a thus formed two-stage or two-step groove comprising a groove 406a having a depth of 42.8µm (t₂) and a groove 406b having a depth of 12.2µm (t₁) (see Figs. 4(i) and 4 (j)). In this connection, the depths t₁ and t₂ (see Fig. 3 (b)) were determined by the observation of Fig. 5 which is an electron microscope photograph showing a cross section of the silicon substrate processed according to the foregoing method.

This Example clearly shows that multiple steps can easily be processed and formed on a substrate in a high precision.

The depth of the foregoing groove 406b is different from that of the groove 405 as shown in Figs. 4 (g) and 4 (h). This is because there is a difference between the etching speed for forming the groove 405 which is obtained through the first etching procedure and that for the etching of the remaining portion which is etched through the first mask 402', when carrying out the secondary etching procedure. When it is necessary to make the depths of these two grooves identical to one another, it would be sufficient that the substrate should previously be etched under such conditions as the depth of the resulting groove 405 is larger than the desired or initially designed one, while preliminarily taking into consideration the form or shape change based on the difference in the foregoing etching speed.

In respect of the depths of these grooves, grooves each having any arbitrary depth can easily be formed depending on the applications of the resulting processed substrate if appropriately setting the etching conditions such as the etching speed. For instance, even if it is needed to form a plurality of grooves having depths identical to each other or to form a plurality of grooves having depths different from each other, such grooves can arbitrarily be formed by appropriately setting the etching conditions. Moreover, it is also possible to form grooves having the same depth by setting such etching conditions that there is not observed any difference in the etching speed while, for instance, increasing the electric voltage applied to the substrate (the bias power) when carrying out the dry etching; or the depths of these grooves can arbitrarily be set by setting the etching conditions, while arbitrarily changing this bias power.

### Example 2

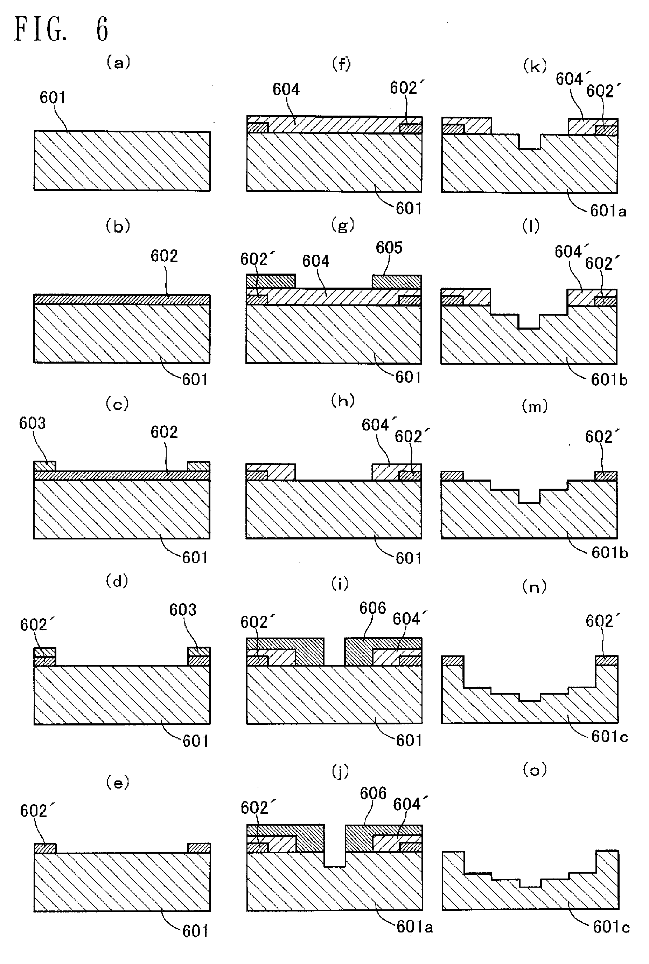

This Example is herein given for describing the processing or formation of a groove having three steps according to the working processes as shown in Figs. 6(a) to 6(o).

First of all, an Al film 602 was formed on a silicon substrate 601 in a thickness of 1µm according to the sputtering technique or the evaporation technique (see Figs. 6(a) and 6(b)). Then a film of OFPR (the trade name of a product available from Tokyo Ohka Kogyo Co., Ltd.) as a photoresist was formed on the Al film 602 and the OFPR film was subjected to the patterning thereof using the photolithography technique to thus obtain a pattern 603 (see Fig. 6(c)). The Al film 602 was subjected to wet-etching using an Al-etching liquid (available from Kanto Chemical Co., Inc.) to thus make the surface of the substrate 601 expose (see Fig. 6(d)), while using the pattern 603 as a mask, and then the pattern 603 was peeled off with acetone to form a first mask 602' made of an Al film (see Fig. 6(e)). A silicon oxide (SiO₂) film 604 was formed, in a thickness of 1µm, on the surface of the first mask 602' thus produced and the exposed surface of the substrate 601 using silane (SiH₄) gas and dinitrogen monoxide (N₂O) gas according to the plasma-assisted CVD technique (see Fig. 6(f)).

An OFPR film was formed on the silicon oxide film 604 and then subjected to a patterning operation using the photolithography technique to thus give a pattern 605 (see Fig. 6(g)). The silicon oxide film 604 was subjected to dry-etching through the pattern 605 as a mask using a C₃F₈ plasma to thus make the surface of the substrate expose and then the pattern 605 was peeled off with acetone to thus give a second mask 604' made of a silicon oxide film (see Fig. 6(h)). An OFPR film was formed on the surface of the substrate thus obtained including the surface of the second mask 604' and then subjected to a patterning operation through the photolithography technique to thus produce a third mask 606 (see Fig. 6(i)).

According to Example 1, the same procedures for the application of a protective film using the DRIE technique and the dry-etching process, under the same conditions, used in Example 1 were repeated except for using the substrate obtained above to thus carry out the etching of the substrate perpendicularly while protecting the side wall of the groove thus formed. More specifically, the dry-etching of the substrate was implemented in such a manner that the shape of the third mask 606 made of OFPR was reflected to thus form a substrate 601a having a groove (see Fig. 6(j)).

Then the third mask 606 was peeled off using acetone (see Fig. 6 (k)), subsequently the substrate was subjected to dry-etching under the same conditions used in the foregoing DRIE technique such that the shape of the second mask 604' consisting of a silicon oxide film was reflected to thus give a substrate 601b having a two-stepped groove (see Fig. 6(l)). Thereafter, the second mask 604' was peeled off through the use of hydrofluoric acid (see Fig. 6(m)). Finally, the substrate 601b was subjected to dry-etching in such a manner that the shape the first mask 602' made of an Al film was faithfully reflected to thus give a substrate 601c having a three-stepped groove (see Fig. 6(n)) and thereafter the first mask 602' was peeled off using an Al-etching liquid (see Fig. 6(o)).

Thus, there could easily be obtained a multi-stepped substrate provided with a groove having three steps, in a high precision.

### Example 3

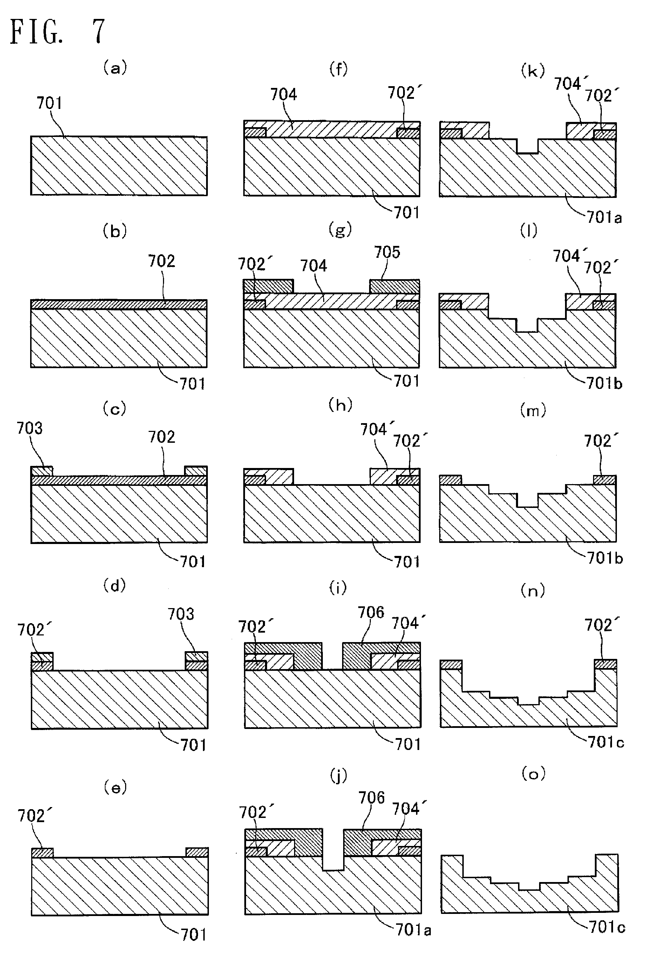

This Example is herein given for describing the processing or formation of a groove having three steps according to the working processes as shown in Figs. 7(a) to 7(o), while using a substrate, materials for forming masks and means for peeling off of the masks, which were all different from those used in Example 2.

First of all, a Cr film 702 was formed, in a thickness of 1µm, on the surface of a silicon dioxide (SiO₂) substrate 701 according to the sputtering technique or the evaporation technique (see Figs. 7(a) and 7(b)). A film of OFPR (the trade name of a product available from Tokyo Ohka Kogyo Co. , Ltd.) as a photoresist was formed on the Cr film 702 and then the photoresist film was subjected to patterning according to the photolithography technique to thus form a pattern 703 (see Fig. 7(c)). The Cr film 702 was etched through the pattern 703 as a mask according to the wet etching technique using a Cr-etching liquid (available from Hayashi Pure Chemical Ind., Ltd.) to thus make the surface of the substrate 701 expose (see Fig. 7(d)). Thereafter, the pattern 703 was peeled off using acetone to thus obtain a first mask 702' made of a Cr film (see Fig. 7(e)). An Si film 704 was formed on the surface of the first mask 702' and the exposed surface of the substrate 701 according to the sputtering technique or the plasma-assisted CVD technique (see Fig. 7(f)).

An OFPR film was formed on the Si film 704 and then subjected to patterning using the photolithography technique to thus obtain a pattern 705 (see Fig. 7(g)). Then the Si film 704 was etched through the pattern 705 as a mask according to the wet etching procedure using an aqueous potassium hydroxide solution to thus make the surface of the substrate expose and subsequently the pattern 705 was peeled off using acetone to thus form a second mask 704' consisting of an Si film (see Fig. 7(h)). Then an OFPR film was formed on the substrate thus produced including the surface of the second mask 704' and subsequently subjected to patterning according to the photolithography technique to give a third mask 706 (see Fig. 7(i)).

The substrate treated according to the foregoing processes, which was introduced into a vacuum chamber, was first placed on an electrostatic chuck and adhered to the same, followed by the evacuation of the chamber to a vacuum, simultaneous with the introduction of an inert gas for cooling into the vacuum chamber under the substrate to thus cool the surface of the substrate in such a manner that the temperature of the surface was set at a level ranging from 80 to 100°C, during the electric discharge process. Then C₃F₈ gas was introduced into the vacuum chamber, while adjusting the pressure within the chamber to 0.5 Pa, an electric power ranging from 500 W to 2 kW was applied to an antenna and an electric power ranging from 50 to 500 W, as a bias power, was applied to the substrate to thus dry-etch the substrate so as to correctly reflect the shape of the third mask 706. Thus, there was obtained a substrate 701a having a groove (see Fig. 7(j)).

Then the third mask 706 was peeled off with acetone (see Fig. 7 (k)) and subsequently the substrate was etched through the second mask 704' consisting of an Si film according to the dry-etching procedures under the same process conditions used above in such a manner that the shape of the second mask was reflected on the substrate to thus give a substrate 701b having a two-stepped groove (see Fig. 7(l)). Thereafter, the second mask 704' consisting of a Si film was peeled off using an aqueous potassium hydroxide solution (see Fig. 7(m)). Finally, the substrate 701b was etched through the first mask 702' consisting of a Cr film according to the dry-etching procedures under the same process conditions used above in such a manner that the shape of the first mask was reflected on the substrate to thus give a substrate 701c having a three-stepped groove (see Fig. 7(n)) and then the first mask 702' was peeled off using a Cr-etching liquid (available from Hayashi Pure Chemical Ind., Ltd.) (see Fig. 7(o)).

Thus, there could easily be obtained a multi-stepped substrate provided with a groove having three steps in a high precision. **Industrial Applicability**

The present invention permits the easy implementation of a multistage step-forming processing of a substrate in a high precision and therefore, the present invention can be applied to the fine processing in the fields of, for instance, the production of semiconductor devices, micro-machines and MEMS devices.

### Explanation of Symbols

101··Substrate; 102··First mask; 103··First groove; 104·· Second mask; 105 · · Second groove; 201, 201a, 201b · · substrate 202 · · First mask; 203 · · Secondmask; 204, 205 · · Groove; 301 · · Substrate; 302, 303 · · Groove; 401, 401a, 401b · · substrate 402 · · Silicon oxide film; 402' · · First mask; 403 · · Pattern; 404 · · Second mask, 405, 406a, 406b · · Groove; 601, 601a, 601b, 601c · · Silicon substrate; 602 · · Al Film; 602' · · First mask; 603 · · Pattern; 604 · · Silicon oxide film; 604' · · Second mask; 605 · · Pattern; 606 · · Thirdmask; 701, 701a, 701b, 701c · · Silicon dioxide substrate; 702 · · Cr Film; 702' · · First mask; 703 · · Pattern; 704 · · Si Film; 704' · · Second mask; 705 · · Pattern; 706 · · Third mask.

## Claims

1. A method for the production of a multi-stepped substrate having a plurality of steps which processes a substrate according to the dry-etching process while making use of a plasma, which comprises forming multiple steps on the substrate by forming, on the principal surface of the substrate, a plurality of masks which are put on top of each other, which differ from each other in materials used for forming the masks and which are likewise different, from each other, in a means for peeling off the same; subjecting, in order, the substrate to dry-etching operations, while reflecting a desired shape of each of the plurality of masks.

2. The method for the production of a multi-stepped substrate as set forth in claim 1, wherein each of the plurality of masks is composed of (1) a light-insensitive organic polymer material selected from the group consisting of phenolic resins, epoxy resins, acrylic resins, methacrylic resins, polyimides, and polyureas; (2) a photoresist having light-sensitivity and comprising, as a principal component, an organic polymer material selected from the group consisting of phenolic resins, epoxy resins, acrylic resins, methacrylic resins, polyimides, and polyureas; (3) a material selected from the group consisting of metals such as Cr, Ti, Pt, Au, Ag, Al, Ni, Cu, Fe, Zr and Ta, an alloy of at least two of them, as well as an oxide and a nitride of the metal listed above; or (4) a material selected from the group consisting of semiconductor film-forming materials, oxides and nitrides of the semiconductor film-forming materials, alloys of the semiconductor film-forming materials and tungsten or molybdenum, and SiON.

3. The method for the production of a multi-stepped substrate as set forth in claim 1, wherein one of the masks is composed of a resin.

4. The method for the production of a multi-stepped substrate as set forth in claim 1 or 3, wherein one of the masks is composed of a chromium film or an aluminum film.

5. The method for the production of a multi-stepped substrate as set forth in any one of claims 1 to 4, wherein the substrate has the surface consisting of silicon, and one of the masks is composed of a silicon oxide film or a silicon nitride film.

6. The method for the production of a multi-stepped substrate as set forth in claim 5, wherein the silicon oxide film or the silicon nitride film used as one of the masks is formed by the evaporation technique, the physical vapor deposition technique, the chemical vapor deposition technique or the spin coating technique.

7. The method for the production of a multi-stepped substrate as set forth in any one of claims 1 to 4, wherein the substrate has the surface consisting of silicon oxide, silicon nitride or SiON, and one of the masks is composed of a silicon film.

8. A method for the production of a multi-stepped substrate which produces a multi-stepped substrate having a plurality of steps by processing a substrate whose surface is composed of silicon according to the dry etching technique while making use of a plasma, wherein the multi-stepped substrate is produced by forming, on the principal surface of a substrate, a plurality of masks which are put on top of each other, which differ from each other in materials used for forming them, which are likewise different, from each other, in a means for peeling off the same and in which one of the plurality of masks is one consisting of a silicon oxide film or a silicon nitride film prepared according to the evaporation technique, the physical vapor deposition technique, the chemical vapor deposition technique or the spin coating technique; and that the substrate is subjected, in order, to dry-etching operations, while reflecting a desired shape of each mask.

9. The method for the production of a multi-stepped substrate as set forth in claim 8, wherein one of the masks is composed of a resin.

10. A method for the production of a multi-stepped substrate which produces a multi-stepped substrate having a plurality of steps by processing a silicon oxide substrate or a silicon nitride substrate according to the dry etching technique while making use of a plasma, wherein the multi-stepped substrate is produced by forming, on the principal surface of the silicon oxide substrate or the silicon nitride substrate, a plurality of masks which are put on top of each other, which differ from each other in materials used for forming them, which are likewise different, from each other, in a means for peeling off the same, and in which one of the plurality of masks is one consisting of a silicon film prepared according to the sputtering technique or the evaporation technique; and that the substrate is subjected, in order, to dry-etching operations, while reflecting a desired shape of each mask.

11. The method for the production of a multi-stepped substrate as set forth in claim 10, wherein one of the masks is composed of a resin.
